(19) Europäisches Patentamt / European Patent Office / Office européen des brevets

(11) **EP 1 412 767 B1**

(12) **EUROPÄISCHE PATENTSCHRIFT**

(45) Veröffentlichungstag und Bekanntmachung des Hinweises auf die Patenterteilung:
**13.08.2008 Patentblatt 2008/33**

(21) Anmeldenummer: **02762391.7**

(22) Anmeldetag: **24.07.2002**

(51) Int Cl.:
***G01R 31/11*** *(2006.01)*

(86) Internationale Anmeldenummer:
**PCT/EP2002/008239**

(87) Internationale Veröffentlichungsnummer:
**WO 2003/012466 (13.02.2003 Gazette 2003/07)**

(54) **VERFAHREN ZUR FEHLERORTUNG INSBESONDERE AN VERZWEIGTEN NIEDER- UND MITTELSPANNUNGSNETZEN UND HIERFÜR VERWENDETE AUSWERTESCHALTUNG**

METHOD AND ERROR LOCATION IN BRANCHED LOW VOLTAGE AND MEDIUM VOLTAGE NETWORKS AND EVALUATION CIRCUIT USED THEREOF

PROCEDE DE LOCALISATION DE DEFAUTS, NOTAMMENT SUR DES RESEAUX BASSE ET MOYENNE TENSION RAMIFIES ET CIRCUIT D'EVALUATION UTILISE A CET EFFET

(84) Benannte Vertragsstaaten:
**AT BE DE FR GB**

(30) Priorität: **26.07.2001 DE 10136344**

(43) Veröffentlichungstag der Anmeldung:
**28.04.2004 Patentblatt 2004/18**

(73) Patentinhaber: **Seba-Dynatronic Mess- und Ortungstechnik GmbH 96148 Baunach (DE)**

(72) Erfinder:
• **SCHLAPP, Hubert 96106 Ebern (DE)**

• **JEHRING, Frieder 01796 Pirna (DE)**

(74) Vertreter: **Riebling, Peter Patentanwalt Postfach 31 60 88113 Lindau (DE)**

(56) Entgegenhaltungen:
**EP-A- 0 768 537        US-A- 4 630 228
US-A- 6 124 717**

**Beschreibung**

Die Erfindung betrifft ein Verfahren zur Fehlerortung an verzweigten Nieder- und Mittelspannungsnetzen und eine hierfür verwendete Auswerteschaltung nach den Oberbegriffen der unabhängigen Patentansprüche. Unter Spannungsnetz werden hierbei elektrische Kabel mit einem oder mehreren Abzweigen verstanden.

Ein derartiges Verfahren ist beispielsweise nach der Strom-Impuls-Methode bekannt geworden.

Aus Vereinfachungsgründen wird in der folgenden Beschreibung nur von einem Kabelnetz gesprochen, obwohl genauer ein Niederspannungsnetz oder ein Mittelspannungsnetz gemeint ist. Derartige Niederspannungs-Netzsysteme sind Stand der Technik zur Verteilung von Energie zwischen Trafostationen und Haushaltungen und z.B. aus EP0 768 537, US 4 630 228 oder US 6 124 717 bekannt. Es wird also allgemein in Bezug auf diese Netze von einem Kabelnetz gesprochen.

Die Erfindung betrifft aber auch die Fehlerortung an verzweigten Mittelspannungsnetzen. Es handelt sich hierbei um die übergeordnete Kabelnetz-Ebene mit Betriebsspannungen über 5 kV.

Bei der Fehlerortung in derartigen Kabelnetzen wurde bisher nach der sogenannten Stromimpuls-Methode gearbeitet.

Hierbei wurde ein Stoßwellengenerator am Einspeisepunkt des Kabelnetzes angeschlossen und durch Entladung des Stoßkondensators des Stoßwellengenerators wurde das Kabelnetz kurzzeitig aufgeladen und der Kabelfehler dann zum Überschlag gebragbt.

Charakteristisch für die verwandte Stromimpuls-Methode ist, dass ein Hochpass-Stromkoppler verwendet wird, um die transienten Anteile des Ausschwingvorganges aufzuzeichnen. Nachteil ist jedoch, dass sich jeder Abzweig im untersuchten Kabelnetz als Reflektionssignal im transienten Anteil niederschlägt. Man erhält also eine praktisch nicht auswertbare Kurve, weil sich alle Abzweige und Endpunkte als Reflektionssignal in der auszuwertenden Kurve niederschlagen.

Grundsätzlich kann hierzu folgendes ausgeführt werden:

Kabelfehlerarten

In Kabelanlagen gibt es verschiedene Fehlerarten. Es gibt Parallel- und Serienfehler. Hier interessieren vor allem die Parallelfehler. Dann gibt es noch die Unterscheidung zwischen permanenten, intermittierenden und Überschlagsfehlern. Permanente Fehler haben einen Parallelwiderstand zwischen den Kabelleitern und sind durch eine Widerstandsmessung zu erkennen. Überschlags- oder Durchschlagsfehler sind dadurch gekennzeichnet, dass sie erst durch Anlegen einer (höheren) Spannung auftreten. Im spannungslosen Zustand sind sie messtechnisch nicht nachzuweisen.

TDR (time domain reflexion)

TDR (time domain reflexion) nennt sich ein gängiges Verfahren zur Vorortung von Fehlerstellen im Kabel. Ein Fehler verursacht eine Impedanzänderung im Kabel und die Pulse, die das TDR aussendet, werden an den Impedanzänderungen zum TDR zurückreflektiert. Aus dem Zeitpunkt des Eintreffens der Reflexionen kann die Entfernung berechnet werden. Zur Erkennung von Überschlagsfehlern wird das TDR Verfahren auch in Kombination mit Hochspannungs-Kondensatorentladungen eingesetzt. Die Kondensatorentladung zündet den Fehler und die Position des brennenden Lichtbogens wird dann mit dem TDR angemessen.

Stromimpuls-Methode (ICE = impulse current equipment)

Ein Kondensator wird auf eine Spannung aufgeladen, die über der Ansprechspannung eines Fehlers liegt. Der Kondensator wird über einen Schalter auf das Kabel entladen und der Fehler schlägt über (oder durch). Es erfolgt ein Ausschwingen der Kondensatorenergie im Kabel. Das Gerät zur Erzeugung dieser Kondensatorentladungen heißt Stoßwellengenerator (SWG). Beim Impulsstromverfahren wird über einen Hochpaß-Stromkoppler der hochfrequente, periodische Anteil des Ausschwingsignales ausgekoppelt und mit einem Transientenrecorder gespeichert. Die Periodizität dieses Signals entspricht der Entfernung zwischen dem Anschlusspunkt und der Fehlerstelle. Man misst den Zeitabstand der periodisch wiederkehrenden Reflexionen. Die Entfernung muss aus der so gemessenen Zeit und der kabeltypischen Ausbreitungsgeschwindigkeit ermittelt werden. Sind im Kabelverlauf andere Reflexionsstellen außer dem Kabelfehler, so führen auch diese Reflexionsstellen zu sichtbaren, anderen Periodizitäten, die die Auswertung erschweren. Solche Reflexionsstellen sind zum Beispiel Abzweige auf Stichkabel oder Änderungen des Kabeltyps (3-phasigeinphasig oder größere Querschnittsänderung).

Verzweigte NSP Netze

In Europa sind die Netze zur Niederspannungsverteilung so aufgebaut, dass ein dreiphasiges Hauptkabel in der Straße verlegt ist und in jedes Haus ein Abzweig führt. Dies hat zur Folge, dass im Hauptkabel eine große Anzahl von abzweigenden Kabeln ist.

Sowohl beim TDR Verfahren, als auch bei ICE sind alle diese Abzweige als prinzipielle Reflexionen zu sehen. Zusätzlich wird die Auswertbarkeit der Bilder noch dadurch reduziert, dass die Stichleitungen an ihren Enden Reflexionen verursachen, die dann auch wieder zur Hauptleitung zurücklaufen und damit im Bild sichtbar werden.

Eine Auswertung der Bilder von stark verzweigten Kabelsystemen ist daher schwierig und Abweichungen sind meist nur durch Vergleich der fehlerhaften Phase mit einer fehlerfreien zu erkennen.

Der Erfindung liegt die Aufgabe zugrunde, ein Verfahren der eingangs genannten Art so weiterzubilden, dass auch in einem verzweigten Nieder- oder Mittelspannungsnetz eine schnelle und fehlerfreie Kabelfehlerortung stattfinden kann.

Zur Lösung der gestellten Aufgabe ist die Erfindung durch folgende Verfahrensschritte gekennzeichnet:

1. In einem ersten Verfahrensschritt wird zunächst die Frequenz der niederfrequenten Komponente des Stoßwellenstromes oder -spannung ermittelt.

2. In einem zweiten Verfahrensschritt wird mittels der "Thomson'schen Schwingkreisformel" aus der bestimmten, niederfrequenten Ausschwingfrequenz mit der bekannten Kapazität des Stoßkondensators die Kreisinduktivität berechnet.

3. In einem dritten Verfahrensschritt wird als Korrekturfaktor die Eigeninduktivität des Stoßkondensators und der Messleitung abgezogen.

4. In einem vierten Verfahrensschritt wird von der berechneten Induktivität ausgehend über den Induktivitätsbelag des Messobjektes die Entfernung zum Fehlerort des Kabelfehlers berechnet.

Mit der gegebenen technischen Lehre wird also ein indirektes Verfahren zur Längenbestimmung eines Fehlerortes eines spannungsabhängigen Fehlers vorgeschlagen. Dies ist ein wesentlicher Vorteil gegenüber dem Stand der Technik, weil nun die von jedem Abzweig oder jedem Endpunkt erzeugte Reflexion nicht mehr bei der Auswertung berücksichtigt werden muss.

Bei der neuen Methode (Niederspannungs-Vorortung) für verzweigte Kabelsysteme wird ein anderer Anteil des an sich bekannten Impulsstromverfahrens ausgewertet. Statt der Filterung des hochfrequenten Anteils wird die sonst unterdrückte gedämpfte Grundwelle aufgezeichnet. Während die hochfrequenten oder transienten Anteile den Verlauf der Impedanz im Kabel widerspiegeln, ist für die Bildung der Grundwelle nur die Kapazität des Stoßkondensators, zuzüglich der Kabelkapazität und die Induktivität des Kabels bis zur Fehlerstelle ausschlaggebend. Die so entstandene Grundwelle ist eine gedämpfte Sinusschwingung und von weiteren Reflexionsstellen im Kabelverlauf unabhängig.

Diese Signalform eignet sich gut zur einfachen numerischen Auswertung. Statt der bei TDR und ICE verwendeten Impuls-Laufgeschwindigkeit des Kabels muss man den Induktivitätsbelag des gemessenen Kabels (oder des Adernpaares) zur Umrechnung der gemessenen Frequenz in die Fehlerentfernung verwenden. Das Verfahren ist aber nicht auf verzweigte Niederspannungsnetze beschränkt. Es lässt sich vorteilhaft in jeder verzweigten Kabelstruktur einsetzen und arbeitet natürlich auch an unverzweigten Kabeln.

Datenerfassung und Auswertung - (Umrechnung L statt V/2)

Die messtechnische Erfassung des NSP_SPG-Signals ist einfach. Bei der aus anwendungstechnisch bedingter Dimensionierung der Stoßgeneratoren kann man die Kabelkapazität vernachlässigen, weil sie viel kleiner ist als die Kapazität des Stoßkondensators. Es wird nur das gedämpfte Ausschwingsignal über den Strom (oder die Spannung) am Ausgang des Stoßgenerators erfasst. Durch den großen Kondensator liegt die Schwingfrequenz zwischen einigen Hundert Herz bis in den niedrigen Kiloherzbereich.

Das Signal wird nach Konditionierung und Schutz mit einem A/D Wandler erfasst und in einem Speicher abgelegt. Der Transientenspeicher kann als Ringspeicher realisiert sein. Durch die Stoßauslösung wird ein Triggersignal erzeugt, das nach einer Verzögerungszeit die Datenerfassung stoppt. Es ist aber auch möglich, den Speichervorgang erst zu starten, wenn das Triggerereignis erkannt wurde.

Aus der gemessenen Schwingungsfrequenz wird die Induktivität berechnet. Die Kapazität des Stoßkondensators wird bei der Herstellung des Gerätes gemessen und abgespeichert. Nach Abzug der geräteeigenen Induktivitäten einschließlich der Verbindungsleitung, erhält man die Induktivität des Messobjektes bis zur Fehlerstelle. Durch Tabellenwerte des Induktivitätsbelages der Messobjekte kann diese dann in die Fehlerentfernung umgerechnet werden.

Wenn das Hauptkabel aus mehreren unterschiedlichen Kabeltypen besteht, so ist es notwendig, die Längen der einzelnen Abschnitte und den Kabeltyp einzugeben. Das Gerät kann dann die Abschnittsinduktvitäten berechnen und damit eine Zuordnung des Fehlerortes zum richtigen Abschnitt treffen.

Die geräteeigene Induktivität lässt sich durch eine Kalibriermessung mit einem Kurzschluss am Ende der Messleitungen mit der gleichen Messelektronik ermitteln und als Korrekturwert ebenfalls im Gerät speichern.

Algorithmen

Bei der Auswertung der Schwingfrequenz kann man einfach die Abstände der Nulldurchgänge oder der Extremwerte manuell ausmessen. Zur Erhöhung der Auswertesicherheit und der Steigerung des Benutzerkomforts ist aber eine automatische numerische Auswertung vorgesehen.

Dabei sollen folgende Algorithmen zum Einsatz kommen:

FFT (Fast Fourier Transform) und/oder CZT (Chirp-Z Transformation) zur Bestimmung der Schwingfrequenz. Ermittlung des Maximums in der FFT (CZT) Darstellung

Ermittlung der Spannungsnulldurchgänge zur Kontrolle der Schwingfrequenz (Fehlererkennung bei der Auswertung)

Tiefpaßfilterung transienter Anteile

Stetigkeitskontrolle des Signals zur Erkennung von Abrissen und unstetig brennenden Fehlerlichtbogen

Ermittlung der Kreisgüte aus der Amplitudendämpfung zur Beurteilung der Lichtbogenqualität

Erkennung von Erdfehlem (Überschlag zum Erdreich) aus dem Signal und Ableitung einer Sicherheitswarnung für den Benutzer

Ausnahmebehandlung gestörter Signale oder von Signalen mit hoher Dämpfung

Die Vorteile der Erfindung liegen in folgenden Merkmalen begründet:

Ortungsverfahren, das von den Reflexionen von Abzweigungen unabhängig ist. Ortungsverfahren, das eine automatische numerische Auswertung ermöglicht.

Auswertung, die Überschläge gegen Erde erkennt und den Benutzer vor Gefahren warnt.

Bestimmung der Fehlerentfernung durch Berechnung der Induktivität des Messobjektes und Verwendung des typischen Induktivitätsbelages des Prüflings.

Messung der Fehlerentfernung durch Bestimmen der Frequenz des Ausschwingens und Berechnung der externen Induktivität.

Messung der Frequenz durch Ermittlung der Zeitintervalle der Nulldurchgänge.

Messung der Frequenz durch Bildung der FFT-Transformierten (Chirp-Z Transformierten) der Ausschwingsignals.

Als Nebenaspekt der Erfindung werden im Folgenden eine Frequenzkorrektur bei sogenannter "niedriger Güte" des Schwingkreises beschrieben, eine Erweiterung des erfindungsgemäßen Verfahrens der Numerischen Auswertung, sowie eine Separierung des Stoßwellenkondensators von der Kabelkapazität. Das Verfahren zur Fehlerortung und die diesbezügliche Auswerteschaltung nach der Erfindung sind aber auf diese Erweiterungen nicht angewiesen, so dass diese lediglich in Abhängigkeit der Merkmale der unabhängigen Ansprüche beansprucht werden.

Frequenzkorrektur bei niedriger Güte

Bei niedrigen Güten des Schwingkreises, wie sie bei Niederspannungskabeln mit geringem Querschnitt (kleiner als 95 mm$^2$) und großen Werten des Stoßkondensators (größer als 100 $\mu$F) auftreten können, gibt es eine prinzipielle Verschiebung der messbaren Ausschwingfrequenz (f) gegen die Frequenz (fo), die mit der Thomson'schen Schwingkreisformel bestimmt werden kann. Die Abweichung der gemessenen Frequenz als Funktion der Güte kann bestimmt werden, nach Gleichung (4).

$$\frac{f}{fo} = \frac{1}{\sqrt{1 + \frac{1}{4Q^2}}} \tag{4}$$

Damit lässt sich der korrigierte Wert der interessierenden Leitungsinduktivität nach Gleichung (5) mit dem bekannten Stoßkondensator Cs berechnen.

$$L_c = \frac{1}{\omega^2 C_s (1 + \frac{1}{4Q^2})} \tag{5} \qquad \omega = 2\pi f$$

Man kann natürlich ebenso die Thomsonfrequenz fo (oder Periodendauer) mit Hilfe von Gleichung (4) berechnen und damit dann, wie in der Druckschrift DE 10136344.3 erläutert, schrittweise die Leitungsinduktivität berechnen.

Die Erfindung besteht also darin, die Güte des Ausschwingvorganges mit zu bestimmen und diese für die Korrektur der Berechnung der Leitungsinduktivität einzusetzen.

Die Güte kann beispielsweise aus dem Abfall der Amplituden aufeinanderfolgender Schwingungen des exponentiell abnehmenden Ausschwingvorganges bestimmt werden, mittels Gleichung (6).

$$Q = -\frac{n * \pi}{\ln(\frac{U_{(tn)}}{U_o})} \tag{6}$$

Wobei Uo die Amplitude am Beginn ist, U(tn) die Amplitude der n-ten Schwingung ist.

Auch andere Verfahren können zur Bestimmung der Güte herangezogen werden. So kann auch der normierte Anstieg a im Nulldurchgang der Schwingung herangezogen werden. Dies ist die erste Ableitung der Spannungsform dividiert durch die Kreisfrequenz

$$a = \frac{u'_{(to)}}{\omega} \tag{7}$$

Auch andere Verfahren zur Bestimmung der Güte sind denkbar.

Erweiterungen des Verfahrens der numerischen Auswertung.

Im Rahmen der Entwicklung des Auswertealgorithmus werden noch einige Lösungen beansprucht. Es wird hier immer Bezug auf die Spannungsform u(t) genommen. Ebenso lassen sich die Prinzipien auch auf die Verwendung der Stromsignals i(t) übertragen.

1. Alternativ kann auch Strom und Spannung simultan erfasst werden. Damit hat man ein komplexes Signal $\bar{v}(t)$ zur weiteren Auswertung.

2. Bildung der ersten u'(t) und zweiten Ableitung u''(t) des Signals u(t) . Sowohl für die Bestimmung der Nulldurchgänge als auch für die Berechnung der Güte können diese Funktionen vorteilhaft benutzt werden. Für die Bestimmung dieser Parameter an Viertelperioden (siehe unten unter 4.) werden sie in jedem Fall benötigt.

3. Berücksichtigung der Nichtlinearitäten des Lichtbogens. An der Fehlerstelle tritt bei der Anwendung dieser Methode immer ein Lichtbogen auf. Der Widerstand dieses Lichtbogens ist stromabhängig und somit bei der exponentiell abnehmenden Schwingung ansteigend. Damit verändern sich aber auch die Güte und damit die messbare Schwingfrequenz. Zur Korrektur berechnet man die Thomsonfrequenz abschnittsweise, vorzugsweise zwischen Nulldurchgängen. In diesen kurzen Zeitabschnitten ist der Lichtbogenwiderstand näherungsweise konstant. Zusätzlich werden noch die Abweichungen der abschnittsweisen Thomsonfrequenzen zur Kontrolle berechnet und für das Gesamtergebnis der Mittelwert der Frequenzen gebildet.

4. Viertelperioden.
Bei Objekten mit sehr niedriger Güte (<1.5) werden die Operationen, die hier unter 1. erläutert sind ausgeführt. Zusätzlich werden noch andere Zeitpunkte bestimmt, um eine Berechnung der Schwingfrequenz zu ermöglichen :

Beginn des Stromflusses to (Sprung in u"(t))
Maximum des Stromflusses t2 (Nulldurchgang von u"(t))
Erster Nulldurchgang der Spannung u(t) t3
Mittenzeitpunkt der gedachten Halbperiode t1

Die Bestimmung der Frequenz und Güte ist mit dieser Methode auch bei verzögertem Einsatz der abklingenden Schwingung t0 (Zündverzögerung des Fehlerlichtbogens) möglich.

5. Filterung und Extrapolation
Zur Unterdrückung von Rausch- und Störanteilen im erfassten Messsignal ist eine Tiefpassfilterung vor der endgültigen Messung von Frequenz und Güte zweckmäßig. Die Filterbandbreite kann adaptiv auf das vorliegende Messsignal angepasst werden. Zur Sicherung der korrekten Wirkung einer nicht-kausalen Filterung des Messsignals (z.B. Linearphasenfilterung, Transversal-Filterung) kann das zu filternde Messsignal in den Zeitabschnitten vor der Fehlerlichtbogen-Zündung (to, siehe oben unter 4.) und nach dem Fehlerlichtbogen-Abriss unter Verwendung von vorab gewonnenen Schätzwerten der Frequenz und der Güte extrapoliert werden.

Separierung des Stoßkondensators von der Kabelkapazität

Bei der Anwendung des Verfahrens im Mittelspannungsbereich treten andere Einflüsse auf, die eine Erweiterung des Verfahrens erfordern. Im Niederspannungsbereich kann i.a. davon ausgegangen werden, dass bei realistischen Kabellängen (kleiner als 1 km) die Kabelkapazität gegenüber der Kapazität des Stoßkondensators vernachlässigt werden kann. Der Fehler liegt in Normalfall unter 1 %. Im Mittelspannungsbereich sind die verwendeten Spannungen höher (üblich bis 32 kV) und damit bei vergleichbaren Stoßenergien die Kapazität geringer. Üblich sind Kapazitätswerte von 2 bis 5 $\mu$F. Zudem sind bei Mittelspannungskabeln die maximalen Längen größer. Ein 20 kV VPE Kabel mit 150 mm$^2$ hat bei 5 km Länge eine Kapazität von 1,25 $\mu$F und liegt damit in der gleichen Größenordnung , wie der Stoßkondensator.
Die Leitungsinduktivität kann daher nicht mehr aus der gemessenen Frequenz und dem bekannten Wert des Stoßkondensators berechnet werden. Die Kabelkapazität Ck summiert sich zur Stoßkapazität Cs und beeinflusst damit die Frequenz ebenso. Die Länge oder besser Fehlerentfernung ist aber nicht bekannt und damit lässt sich deren Einfluss aber nicht einfach eliminieren.
Nachdem man somit zwei Unbekannte (Kabelkapazität und Leitungsinduktivität Lk), aber nur eine Bestimmungsgleichung (8) für die Kreisfrequenz w hat, ist die Separierung nicht möglich.

$$\omega^2 = \frac{1}{(C_s + C_k)L_k}$$

$$(8)$$

Man benötigt eine zweite Bestimmungsgleichung. Dazu könnte man eine zweite Messung mit einer anderen Stoßkapazität machen. Dies erfordert aber einen erheblichen Aufwand, da die Kondensatoren umgeschaltet werden müssen und die dazu nötigen Schalter für hohe Spannung und hohe Pulsströme lange Schaltzeiten haben und aufwendig sind. Außerdem benötigt man aufteilbare Kondensatoren und man muss zwei Messungen durchführen um ein Resultat zu erzielen. Bei Überschlagsfehlern ist es aber nicht immer sicher, dass man zwei erfolgreiche Messungen hintereinander durchführen kann.

Es wird daher ein anderer Ansatz gewählt. Durch Einbeziehen von a priori Informationen über das Messobjekt, nämlich der Kabeleigenschaften, kann man die Separierung erreichen.

Die Kabelinduktivität und -kapazität sind bekannte Eigenschaften und in den Projektierungsdaten der Hersteller als Leitungsbeläge aufgelistet. Für die Umrechung der Kabelinduktivität in eine Fehlerentfernung, wird der induktive Leitungsbelag der Kabel sowieso benötigt. Dazu wird im Gerät eine Kabeltabelle gespeichert, aus der der Benutzer den vorliegenden Kabeltyp auswählt. Diese Kabeltabelle wird um den Kapazitätsbelag ergänzt. Damit lässt sich nach Gleichung (9) die Kabelimpedanz berechnen.

$$Z_k = \sqrt{\frac{L_k}{C_k}} = \sqrt{\frac{L'}{C'}} \qquad (9)$$

Worin L' und C' für die Leitungsbeläge des Kabels stehen.

Mit der Kabelimpedanz Zk kann in Gleichung (8) die Kabelkapazität substituiert werden (10).

$$\omega^2 = \frac{1}{\frac{L_k^2}{Z_k^2} + L_k C_s} \qquad (10)$$

Diese Gleichung (10) enthält, außer Lk , nur bekannte Größen und kann nach Lk aufgelöst werden.

$$L_k = \frac{Z_k^2}{2} \left( \sqrt{C_s^2 + \frac{4}{Z_k^2 \omega^2}} - C_s \right) \qquad (11)$$

Cs = 2 $\mu$F, SWG 1000C-1 in Position 32 kV, VPE 20KV 150mm2, Zk= 38 Q f=5,48 kHz bei 1 km Kabel, f=13 kHz bei 200m

Es wird damit also beansprucht, dass man aus nur einer Messung mit Hilfe der tabellierten Kabelimpedanz die Mehrdeutigkeit eliminiert und die Kabelinduktivität berechnen kann.

Im folgenden wird die Erfindung anhand von mehrere Ausführungswege darstellende Zeichnungen näher erläutert. Hierbei gehen aus den Zeichnungen und ihrer Beschreibung weitere Merkmale und Vorteile der Erfindung hervor.

Es zeigen:

Figur 1: Schematisiert ein Kabelnetz mit Abzweigen
Figur 2: Schematisiert einen Stoßwellengenerator mit dem Anschluss an ein Kabelnetz nach Figur 1
Figur 3: Auswertung eines Strombildes aus dem Kabelnetz bei Position 23 in Figur 2
Figur 4: Auswertung eines Spannungsbildes bei Position 22 in Figur 2
Figur 5: Auswertung des gleichen Spannungsbildes mit Darstellung der Messpunkte zur Frequenzbestimmung
Figur 6: Schematisiert ein Spannungsbild, ähnlich wie Figur 5 an Position 22
Figur 7: Die Chirp-Z-transformierte Kurve von Figur 6
Figur 8: Gleiche Kurve wie Figur 7. Nach Anwendung eines Hanning-Fensters nach Figur9.
Figur 9: Das Hanning-Fenster zur Anwendung in Figur 8
Figur 10: Schematisiert eine Ausverteschaltung zur Verwirklichung des Verfahrens

Zunächst wird darauf hingewiesen, dass Schutz in der vorliegenden Erfindung nicht nur für das Verfahren, sondern davon unabhängiger Schutz auch für die verwendete Schaltung beansprucht wird.

Es wird darauf hingewiesen, dass wesentlich bei der Erfindung ist, dass als Auswertekriterium die Induktivität des gemessenen Kabelnetzes verwendet wird, weil diese Induktivität unabhängig von den Abzweigungen ist.

Damit wird also der Vorteil erreicht, dass hochfrequente Auswertesignale nicht mehr die Messung beeinträchtigen können.

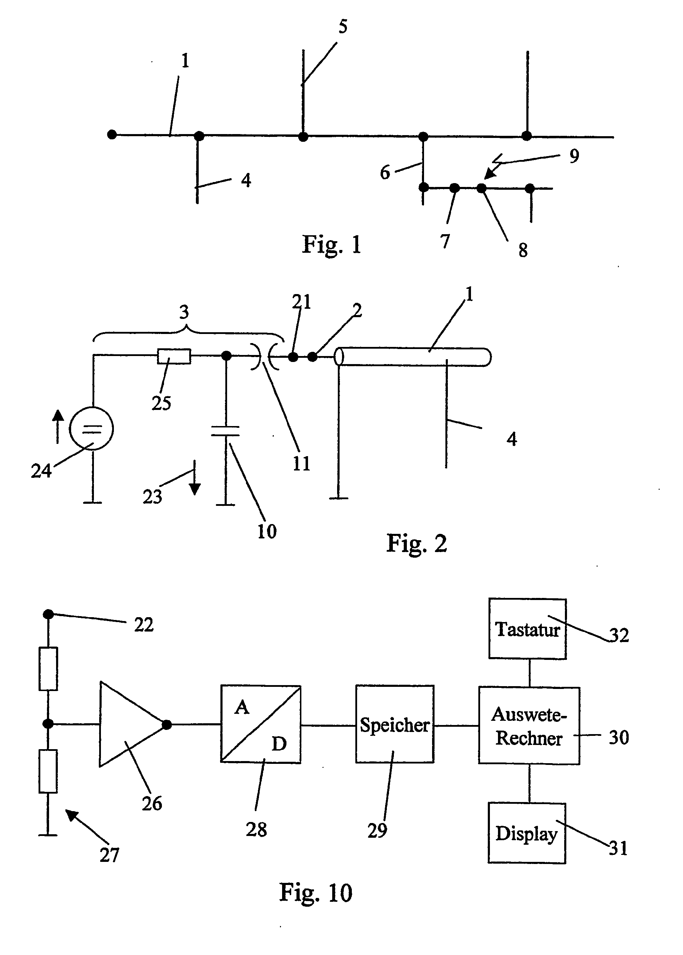

In Figur 1 ist schematisiert ein auszuwertendes Kabelnetz mit einem spannungsabhängigen Fehler 9 am Fehlerort 8 dargestellt.

Das Kabelnetz besteht im wesentlichen aus einer Hauptleitung 1, an der an einem Anschlusspunkt 2 die Messanordnung ansetzt.

Die Messanordnung besteht im wesentlichen aus dem in Figur 2 dargestellten Stoßwellengenerator 3, der eine Hochspannungsquelle 24 mit Innenwiderstand 25 aufweist und ein hierzu gehörender Stoßkondensator 10. Die hiermit erzeugte Spannung wird über die Funkenstrecke 11 schlagartig entladen.

Über den Anschlusspunkt 2 wird die Stoßwelle in die mehrere Abzweige 4, 5, 6 aufweisende Hauptleitung 1 eingespeist, wobei der Fehlerort 8 sogar noch in einem Nebenabzweig 7 vom Abzweig 6 liegen kann.

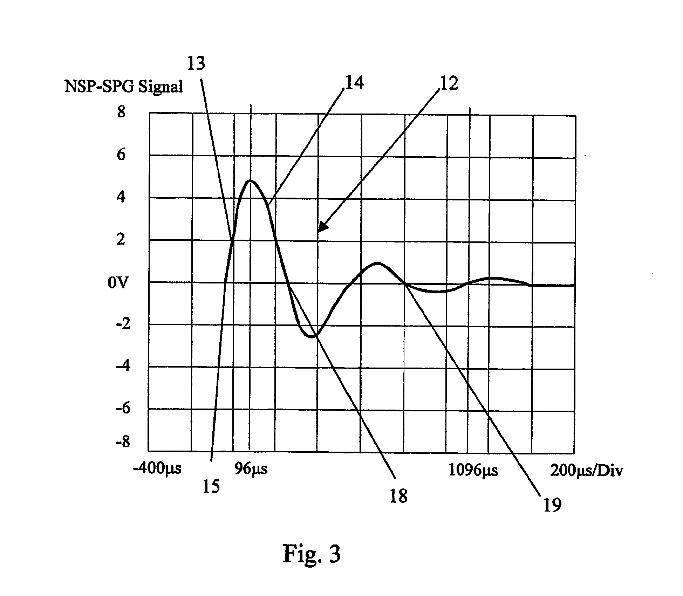

Die Figur 3 zeigt die Auswertung des Strombildes, wie es durch einen entsprechenden Abgriff am Fußpunkt bei Position 23 ermittelt werden kann.

Bei Position 15 erfolgt die Entladung der Stoßwellenspannung, die zum Stromanstieg führt, und es ist erkennbar, dass in dieser gedämpften Schwingung 12, die vom Fehlerort 8 rückwärts in die Hauptleitung 1 eingespeist wird, auch eine Hochfrequenzkomponente 13 enthalten ist. Erfindungsgemäß wird nun diese Hochfrequenzkomponente 13 gerade nicht ausgewertet, sondern nur die niederfrequente Schwingung 14 insgesamt der gedämpften Schwingung 12.

Damit besteht also der Vorteil, dass die Hochfrequenzkomponente 13 nicht mehr in das Messergebnis einbezogen wird.

Beispielsweise wird nun erfindungsgemäß zwischen den Positionen 18 und 19 die Periodendauer bestimmt.

Alternativ kann statt der Auswertung des Strombildes bei Position 23 auch das Spannungsbild als Abgriff an den Positionen 21 oder 22 bestimmt werden.

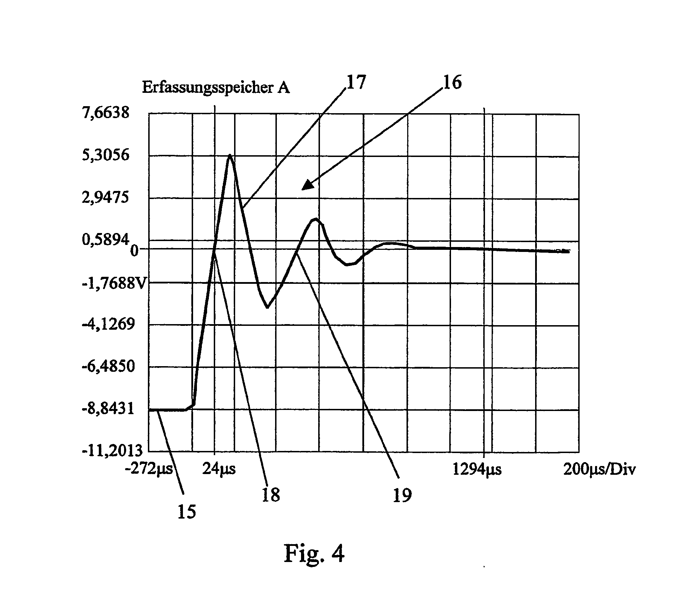

Auch bei diesem Spannungsbild nach Figur 4 entsteht eine gedämpfte Schwingung 16, deren niederfrequente Schwingung 17 ausgewertet wird. Die Auswertung kann hierbei ebenfalls zwischen Position 18 und 19 erfolgen.

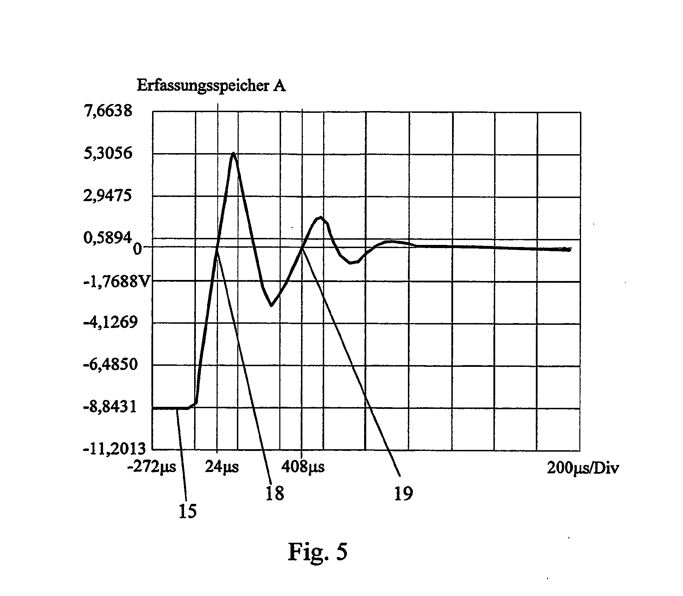

In Figur 5 ist im wesentlichen die gleiche Kurve dargestellt, wobei nochmals erläutert wird, wie die Auswertung im Einzelnen erfolgt.

Es wird also die Ermittlung der Schwingfrequenz über die Nulldurchgänge der gedämpften Schwingung verwirklicht.

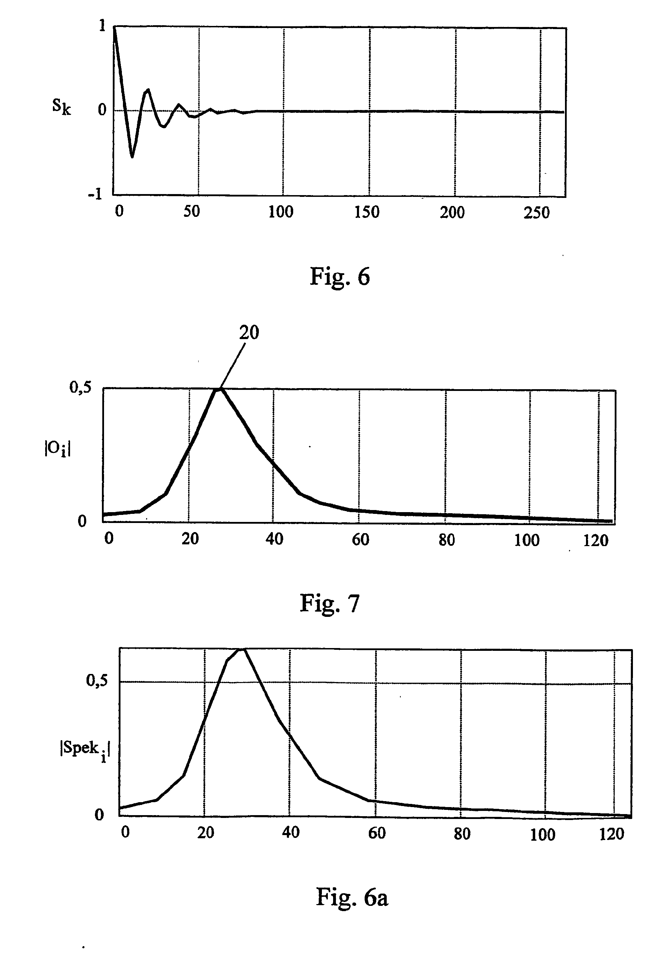

Alternativ erfolgt noch ein weiteres Berechnungsverfahren nach den Figuren 6 - 9.

Zunächst wird aber das weitere Auswerteverfahren näher erläutert.

Berechnen der Kabelinduktivität aus der gemessenen Periodendauer $\mathrm{T}p$

$$ f := 1/\mathrm{T}p \qquad\qquad (1) $$

$$ \omega := 2\pi f \qquad\qquad (2) $$

$\pi = 3.1416...$

$$ Lo := 1/C\omega^2 \qquad\qquad (3) $$

Von der berechneten Induktivität Lo muss dann noch die Eigeninduktivität des SWG-Teils und der Messleitungen abgezogen werden. Sie beträgt ca. 5.4 µH im 4 kV Bereich.

Ein Ausführungsbeispiel dieser Berechnung wird nachfolgend wiedergegeben.

Bei der NSP-Demostrecke ist die im 4 kV Bereich gemessene Periodendauer 388 µs bei Funkenstrecke.

Damit ergibt sich eine Schwingfrequenz von 2,58 kHz. Der Stoßkondensator im Mustergerät 1 hat eine Kapazität von 129 µF in der 4 kV Stellung.

Daraus wird eine Gesamtinduktivität von 29,4 µH berechnet. Abzüglich der Eigeninduktivität des SWG und der Messleitung von 5,4 μH sind das für die Kabelinduktivität 23,8 μH.

Ein Kabel NAYY 4*150 hat 457 μH/km bei Messung zwischen blau und gelb/grün. Bei Messung zwischen blauem und gelb/grünem Leiter sind es ca. 365 μH/km. Bei der Auswertung muss daher unterschieden werden, ob die Ader gegenüberliegt oder benachbart ist.

Damit ergibt sich die Fehlerentfernung zu 23,8 / 457 = 0,052 km oder 52 m.

In einem alternativen Auswerteverfahren erfolgt die Auswertung mittels einer Berechnung der Fourier-transformierten gedämpften Schwingung.

Es wird also eine Chirp-Z-Transformation verwirklicht.

Figur 6 zeigt ein Zeitsignal, wie es in der gleichen Weise auch in Figur 4 und 5 dargestellt ist, nur dass eine positive Polarität gezeichnet wurde.

Die Fourier-transformierte Kurve aus Figur 6 ist in Figur 6a dargestellt.

Anstatt der Fourier-transformierten Kurve nach Figur 6a wird nun erfindungsgemäß die Chirp-Z-transformierte Kurve nach Figur 7 ermittelt.

Beide Berechnungsmethoden werden jedoch als Erfindung wesentlich beansprucht, dass heißt sowohl die Fourier-transformierte-Kurve nach Figur 6a als auch die Chirp-Z-transformierte Kurve werden jeweils alternativ zur Berechnung herangezogen.

Genauer handelt es sich um eine FFT-Berechnung nach Figur 6a.

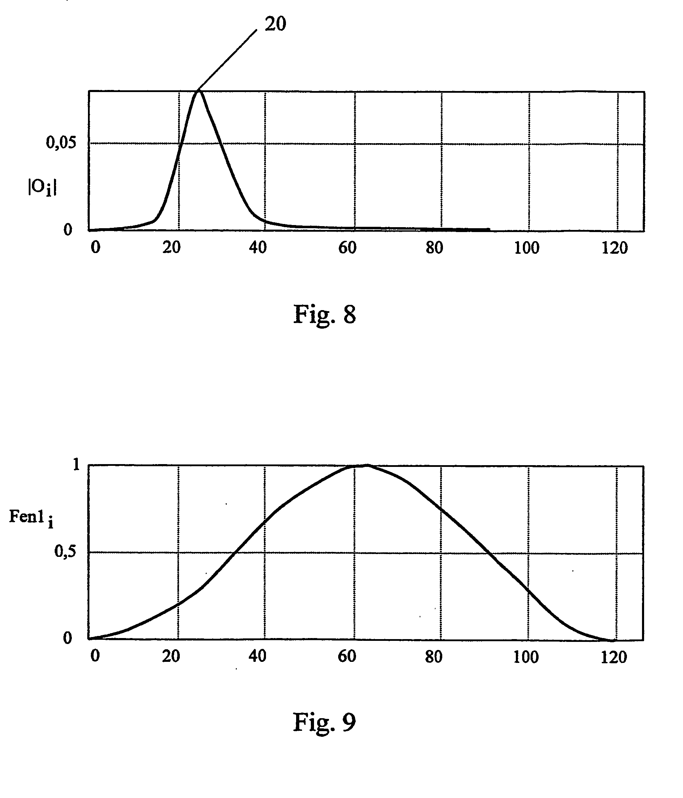

In der Kurve nach Figur 7 und Figur 8 wird nun erfindungsgemäß das Frequenzmaximum bei Position 20 bestimmt und das Frequenzmaximum bei Position 20 gibt dann die Schwingungsfrequenz wieder. Bei einer stark gedämpften Schwingung erfolgt eine verbesserte Auswertung, welche über ein sogenanntes Hanning-Fenster verwirklicht wird. Dieses Hanning-Fenster ist in Figur 9 dargestellt.

Die Maximumbestimmung nach Figur 8 wird durch die Anwendung des Hanning-Fensters nach Figur 9 erleichtert. Die Auswertung mittels des Hanning-Fensters nach Figur 9 ist also bereits in Figur 8 schon verwirklicht worden.

Erfindungsgemäß wird also das Eingangssignal mit einem Hanning-Fenster gewichtet und führt dann zu der Auswertung in der Kurve Figur 8.

Statt des hier gezeigten Hanning-Fensters, zur verbesserten Auswertung können selbstverständlich auch noch andere Fensterfunktionen verwendet werden, wie z.B. Hanning-Fenster oder Blackman-Fenster oder dergleichen.

In Figur 10 ist eine Auswerteschaltung dargestellt, die allgemein unabhängigen Schutz von dem vorgenannten Verfahren genießen soll.

Die Anschaltung des Verstärkers 26 erfolgt über einen Spannungsteiler 27 bei Position 22 in Figur 2.

Bei Abgriff einer Stromkurve entfällt der Spannungsteiler 27 und es erfolgt ein direkter Anschluss des Eingangs des Verstärkers 26 an einen entsprechenden Stromanschluss etwa bei Ziffer 23 in Figur 2.

Der Verstärker 26 arbeitet mit einem AD-Wandler 28 zusammen, der die niederfrequente Schwingung 14, 17 der gedämpften Schwingung 12, 16 digitalisiert.

Die digitalisierten Werte werden in einem digitalen Speicher 29 abgelegt und einem Auswerterechner 30 zugeführt. Der Auswerterechner 30 führt dann die beiden Berechnungsverfahren entweder nach den Figuren 3 - 5 oder alternativ nach den Figuren 6-9 durch.

Selbstverständlich wird auch die Längenberechnung in diesem Auswerterechner 30 verwirklicht. Das Ergebnis kann auf einem Display 31 ausgegeben werden.

Entsprechende Eingabewerte sind über eine Tastatur 32 einzugeben.

Wichtig bei der Auswerteschaltung nach Figur 10 ist deren einfacher Aufbau, weil lediglich die niederfrequenten Schwingungen 14, 17 ausgewertet werden müssen. Die Auswertung erfolgt automatisch nach Eingabe der Kabelsorte vollautomatisch. Es findet also eine vollautomatische Ermittlung des spannungsabhängigen Fehlers 9 am Fehlerort 8 statt.

Bei den Vorteilen, die im allgemeinen Teil benannt wurden, war u.a. auch angegeben, dass eine Auswertung der Überschläge gegen Erde erkannt werden kann und der Benutzer vor Gefahren gewarnt werden kann. Dies bedeutet folgendes:

Bei der Auswertung der erfindungsgemäßen Schwingungsform tritt im Fall eines Erdüberschlages keine gedämpfte Oszillation auf, sondern ein aperiodischer Ausschwingvorgang. Bei der Auswertung des Messsignals kann dieser aperiodische Ausschwingvorgang erkannt werden und ein Warnhinweis für den Benutzer erzeugt werden, weil auch derartige aperiodische Ausschwingvorgänge von der erfindungsgemäßen Schaltung erkannt werden und ausgewertet werden.

Die Erfindung betrifft also zusammenfassend ein Verfahren zur Fehlerortung an verzweigten Nieder- und Mittelspannungsnetzen und eine hierfür verwendete Auswerteschaltung, wobei folgende Verfahrensschritte durchlaufen werden: Zunächst wird die Frequenz der niederfrequenten Komponente des Stoßwellenstromes oder -spannung ermittelt, dann wird mittels der "Thomson'schen Schwingkreisformel" aus der bestimmten, niederfrequenten Ausschwingfrequenz die Kreisinduktivität berechnet, anschließend wird als Korrekturfaktor die Eigeninduktivität des Stoßkondensators und der Messleitung abgezogen, schließlich wird von der berechneten Induktivität ausgehend über den Induktivitätsbelag des Messobjektes die Entfernung zum Fehlerort des Kabelfehlers berechnet.

Die Auswertung kann, wie beschrieben, Schritt für Schritt erfolgen. Es ist aber auch möglich, die Schritte zusammen zu fassen und mittels einer Formel in welche nur die gemessene Zeitdauer und der Induktivitätsbelag eingesetzt wird, die Kabellänge zu berechnen.

Vorteil hierbei ist, dass auch in einem verzweigten Nieder- oder Mittelspannungsnetz eine schnelle und fehlerfreie Ortung von spannungsabhängigen Kabelfehlern mittels Längenbestimmung stattfinden kann, ohne dass Signalreflexionen an Abzweigungen oder Endpunkten der Kabel stören.

Die Auswerteschaltung hat einen Konditionier- und Schutzbaustein, einen A/D-Wandler und mindestens einen Speicher, sowie einen Auswerterechner für das Signal.

**Zeichnungslenende**

| | |
|---|---|
| 1 | Hauptleitung |
| 2 | Anschlusspunkt |
| 3 | Stoßwellengenerator |
| 4 | Abzweig |
| 5 | Abzweig |
| 6 | Abzweig |
| 7 | Nebenabzweig |
| 8 | Fehlerort |
| 9 | spannungsabhängigen Fehler |
| 10 | Stoßkondensator |
| 11 | Funkenstrecke |
| 12 | gedämpfte Schwingung (Strombild) |
| 13 | Hochfrequenzkomponente (nicht ausgewertet) |
| 14 | niederfrequente Schwingung (ausgewertet) |
| 15 | Position |
| 16 | gedämpfte Schwingung (Spannungsbild) |
| 17 | niederfrequente Schwingung |
| 18 | Position |
| 19 | Position |
| 20 | Position |
| 21 | Position (Abgriff mit Spannungsteiler) |
| 22 | Position (Abgriff mit Spannungsteiler) |
| 23 | Position (Strommessung) |
| 24 | Hochspannungsquelle |
| 25 | Innenwiderstand |
| 26 | Verstärker |
| 27 | Spannungsteiler |
| 28 | A/D-Wandler |
| 29 | Speicher |
| 30 | Auswerterechner |
| 31 | Display |
| 32 | Tastatur |

**Patentansprüche**

1. Verfahren zur Fehlerortung insbesondere an verzweigten Nieder- und Mittelspannungsnetzen mittels Impulsmethode, wobei folgende Schritte durchgeführt werden:

   a) Ermitteln der Frequenz der niederfrequenten Komponente des Stoßwellenstromes oder -spannung;
   b) Berechnen der Kreisinduktivität mittels der "Thomson'schen Schwingkreisformel" mit der bekannten Kapazität des Stoßkondensators aus der bestimmten, niederfrequenten Ausschwingfrequenz;
   c) Subtrahieren der Eigeninduktivität des Stoßkondensators und der Messleitung als Korrekturfaktor;
   d) Berechnen der Entfernung zum Fehlerort des Kabelfehlers, von der berechneten Induktivität ausgehend über den Induktivitätsbelag des Messobjektes.

2. Verfahren nach Anspruch 1, **dadurch gekennzeichnet, dass** die Auswertung der Schwingfrequenz manuell oder automatisch messtechnisch durch Ausmessen der Abstände der Nulldurchgänge und/oder der Extremwerte erfolgt.

3. Verfahren nach einem der Ansprüche 1 oder 2, **dadurch gekennzeichnet, dass** die Auswertung der Schwingfrequenz über FFT (Fast Fourier Transform) und/oder CZT (Chirp-Z Transformation) erfolgt.

4. Verfahren nach Anspruch 3, **dadurch gekennzeichnet, dass** die Ermittlung des Maximums in der FFT und/oder (CZT) Darstellung erfolgt.

5. Verfahren nach einem der Ansprüche 1 bis 4, **dadurch gekennzeichnet, dass** eine Ermittlung der Spannungsnulldurchgänge zur Kontrolle der Schwingfrequenz zur Fehlererkennung bei der Auswertung erfolgt.

6. Verfahren nach einem der Ansprüche 1 bis 5, **dadurch gekennzeichnet, dass** eine Tiefpaßfilterung transienter Anteile erfolgt.

7. Verfahren nach einem der Ansprüche 1 bis 6, **dadurch gekennzeichnet, dass** eine Stetigkeitskontrolle des Signals zur Erkennung von Abrissen und unstetig brennenden Fehlerlichtbogen erfolgt.

8. Verfahren nach einem der Ansprüche 1 bis 7, **dadurch gekennzeichnet, dass** die Ermittlung der Kreisgüte aus der Amplitudendämpfung zur Beurteilung der Lichtbogenqualität erfolgt.

9. Verfahren nach einem der Ansprüche 1 bis 8, **dadurch gekennzeichnet, dass** eine Erkennung von Erdfehlern bzw. ein Überschlag zum Erdreich aus dem Signal und eine Ableitung einer Sicherheitswarnung für den Benutzer erfolgt.

10. Verfahren nach einem der Ansprüche 1 bis 9, **dadurch gekennzeichnet, dass** eine Ausnahmebehandlung gestörter Signale oder von Signalen mit hoher Dämpfung erfolgt.

11. Verfahren nach einem der Ansprüche 1 bis 10, **dadurch gekennzeichnet, dass** das Signal nach Konditionierung und Schutz mittels mindestens einem elektrischen Baustein (26, 27) mit mindestens einem A/D Wandler (28) erfasst und in mindestens einem digitalen Speicher (29) abgelegt wird.

12. Verfahren nach einem der Ansprüche 1 bis 11, **dadurch gekennzeichnet, dass** durch die Stoßauslösung ein Triggersignal erzeugt wird, das nach einer Verzögerungszeit die Datenerfassung stoppt.

13. Verfahren nach einem der Ansprüche 1 bis 11, **dadurch gekennzeichnet, dass** der Speichervorgang erst gestartet wird, wenn ein Triggerereignis erkannt wurde.

14. Verfahren nach einem der Ansprüche 1 bis 13, **dadurch gekennzeichnet, dass** die Kapazität des Stoßkondensators (10) und/oder die gerätespezifischen Induktivitäten und/oder mindestens tabellarische Werte des Induktivitätsbelages der Messobjekte und/oder ggf. Längen und Typ der Abschnitte der Kabel in einem Speicher der Auswerteschaltung gespeichert sind und abrufbar sind.

15. Verfahren nach einem der Ansprüche 1 bis 14, **dadurch gekennzeichnet, dass** die geräteeigene Induktivität mittels Kalibriermessung durch Kurzschluss am Ende der Messleitungen ermittelt wird.

16. Auswerteschaltung zur Fehlerortung an verzweigten Nieder- und Mittelspannungsnetzen mittels Impulsmethode, **dadurch gekennzeichnet, dass** die Auswerteschaltung mindestens einen Konditionier- und Schutzbaustein (26, 27), mindestens einen A/D-Wandler (28), mindestens einen Speicher (29) und mindestens ein Auswerterechner (30) für das Signal beinhaltet, wobei der Auswertrechner geeignet ist alle Schritte des Verfahrens nach einem der Ansprüche 1-15 und 26-35 auszuführen.

17. Auswerteschaltung nach Anspruch 16, **dadurch gekennzeichnet, dass** dem mindestens einen Konditionier- und Schutzbaustein (26, 27) der mindestens eine A/D-Wandler (28) nachgeschaltet ist, welchem mindestens der eine Speicher (29) nachgeschaltet ist, dem wiederum der mindestens eine Auswerterechner (30) nachgeschaltet ist.

**18.** Auswerteschaltung nach einem der Ansprüche 16 oder 17, **dadurch gekennzeichnet, dass** der Konditionier- und Schutzbaustein (26, 27) mindestens einen Verstärker (26) beinhaltet.

**19.** Auswerteschaltung nach Anspruch 18, **dadurch gekennzeichnet, dass** der Verstärker (26) mit mindestens einem Spannungsteiler (27) beschaltet ist.

**20.** Auswerteschaltung nach einem der Ansprüche 16 bis 19, **dadurch gekennzeichnet, dass** der Speicher (29) ein digitaler Speicher ist.

**21.** Auswerteschaltung nach einem der Ansprüche 16 bis 20, **dadurch gekennzeichnet, dass** der Speicher (29) ein Ringspeicher ist und als Transientenspeicher ausgebildet ist.

**22.** Auswerteschaltung nach einem der Ansprüche 16 bis 21, **dadurch gekennzeichnet, dass** der Auswerterechner (30) dafür geeignet ist, die Berechnungsschritte des Verfahrens nach einem der Ansprüche 1 bis 15 durchzuführen.

**23.** Auswerteschaltung nach Anspruch 22, **dadurch gekennzeichnet, dass** der Auswerterechner (30) auch dafür geeignet ist, eine Längenberechnung der zu prüfenden Kabel durchzuführen.

**24.** Auswerteschaltung nach einem der Ansprüche 16 bis 23, **dadurch gekennzeichnet, dass** dem Auswerterechner (30) mindestens ein Ausgabegerät (31) und/oder mindestens ein Eingabegerät (32) anschließbar ist.

**25.** Auswerteschaltung nach einem der Ansprüche 16 bis 24, **dadurch gekennzeichnet, dass** das Ausgabegerät (31) mindestens ein Display enthält und/oder das Eingabegerät (32) mindestens eine Tastatur.

**26.** Verfahren nach einem der Ansprüche 1 bis 15, **dadurch gekennzeichnet, dass** die Güte des Ausschwingvorganges bestimmt wird und eine Korrektur der Berechnung der Leitungsinduktivität oder der gemessenen Frequenz bzw. Periodendauer erfolgt.

**27.** Verfahren nach Anspruch 26, **dadurch gekennzeichnet, dass** die Bestimmung der Güte des Ausschwingvorganges bzw. des Schwingkreises aus dem Abfall der Amplituden aufeinanderfolgender Schwingungen des exponentiell abnehmenden Ausschwingvorganges erfolgt und/oder durch den normierten Anstieg im Nulldurchgang der Schwingung, der die erste Ableitung der Spannungsform dividiert durch die Kreisfrequenz darstellt.

**28.** Verfahren nach einem der Ansprüche 1 bis 15 und 26 oder 27, **dadurch gekennzeichnet, dass** die Auswertung der Schwingfrequenz durch simultanes Erfassen von Strom und Spannung erfolgt und das somit erhaltene komplexe zeitlich abhängige Signal zur weiteren Auswertung heranzieht.

**29.** Verfahren nach Anspruch 28, **dadurch gekennzeichnet, dass** bei Objekten mit sehr niedriger Güte (etwa kleiner 1.5) zusätzlich noch andere Zeitpunkte bestimmt werden, um eine Berechnung der Schwingfrequenz zu ermöglichen, nämlich der Beginn des Stromflusses (Spannungssprung am Ausgang) und/oder das Maximum des Stromflusses (Nulldurchgang von u"(t) ) und/oder der erste Nulldurchgang der Spannung und/oder der Mittenzeitpunkt der gedachten Halbperiode.

**30.** Verfahren nach einem der Ansprüche 1 bis 15 und 26 oder 27, **dadurch gekennzeichnet, dass** die Auswertung der Schwingfrequenz durch Bestimmen der Nulldurchgänge der ersten und zweiten zeitlichen mathematischen Ableitung erfolgt, welche auch für die Bestimmung der Güte des Ausschwingvorganges bzw. des Schwingkreises hergenommen werden können.

**31.** Verfahren nach einem der Ansprüche 1 bis 15 und 26 oder 27, **dadurch gekennzeichnet, dass** die Auswertung der Schwingfrequenz durch abschnittsweises Berechnen der Thomsonfrequenz erfolgt, vorzugsweise zwischen den kurzen Zeitabschnitten der Nulldurchgänge, wo der Lichtbogenwiderstand näherungsweise konstant ist, und zusätzlich noch die Abweichungen der abschnittsweisen Thomsonfrequenzen zur Kontrolle berechnet werden und für das Gesamtergebnis der Mittelwert der Frequenzen gebildet wird.

**32.** Verfahren nach einem der Ansprüche 1 bis 15 und 26 oder 27, **dadurch gekennzeichnet, dass** zur Unterdrückung von Rausch- und Störanteilen im erfassten Messsignal eine Tiefpassfilterung vor der endgültigen Messung von Frequenz und Güte erfolgt, wobei die Filterbandbreite adaptiv auf das vorliegende Messsignal angepasst wird.

33. Verfahren nach Anspruch 32, **dadurch gekennzeichnet, dass** zur Sicherung der korrekten Wirkung einer nicht-kausalen Filterung des Messsignals (z.B. Linearphasenfilterung, Transversal-Filterung) das zu filternde Messsignal in den Zeitabschnitten vor der Fehlerlichtbogen-Zündung und nach dem Fehlerlichtbogen-Abriss unter Verwendung von vorab gewonnenen Schätzwerten der Frequenz und der Güte extrapoliert wird.

34. Verfahren nach einem der Ansprüche 1 bis 15 und 26 bis 33, **dadurch gekennzeichnet, dass** mit nur einer Messung mit Hilfe einer tabellierten Kabelimpedanz die Kabelinduktivität berechnet wird, wobei diese Korrektur nur erfolgt, wenn die Kapazität des Meßobjektes (Kabels) gegenüber der Kapazität des Stoßgenerators nicht vernachlässigt werden kann.

35. Verfahren nach Anspruch 34, **dadurch gekennzeichnet, dass** die tabellierte Kabelimpedanz mittels einer um den Kapazitätsbelag ergänzten Kabeltabelle, die im Gerät gespeichert ist, berechnet wird.

**Claims**

1. Method for fault tracing in particular in branched low-voltage and medium-voltage networks by means of an impulse method, wherein the following steps are carried out:

   a) determining the frequency of the low-frequency component of the impulse wave current or voltage;
   b) calculating the circuit inductance by means of the "Thomson's resonant circuit formula" using the known capacitance of the impulse capacitor from the determined, low-frequency transient oscillation frequency;
   c) subtracting the self-inductance of the impulse capacitor and of the measurement line as a correction factor;
   d) calculating the distance to the fault location of the cable fault starting from the calculated inductance via the inductance of the measurement object.

2. Method according to claim 1, **characterised in that** the oscillation frequency is evaluated manually or automatically by measurement techniques, by measuring the intervals between the zero crossings and/or the extreme values.

3. Method according to either of claims 1 or 2, **characterised in that** the oscillation frequency is evaluated by means of FFT (Fast Fourier Transform) and/or CZT (Chirp-Z Transformation).

4. Method according to claim 3, **characterised in that** the maximum is determined in the FFT and/or CZT representation.

5. Method according to any one of claims 1 to 4, **characterised in that** the voltage zero crossings are determined in order to check the oscillation frequency for fault identification during the evaluation process.

6. Method according to any one of claims 1 to 5, **characterised in that** transient components are low-pass filtered.

7. Method according to any one of claims 1 to 6, **characterised in that** a continuity check is carried out on the signal in order to identify interruptions and intermittently burning fault arcs.

8. Method according to any one of claims 1 to 7, **characterised in that** the quality of the circuit is determined from the amplitude attenuation in order to assess the arc quality.

9. Method according to any one of claims 1 to 8, **characterised in that** earth faults or a flashover to earth are identified from the signal and a safety warning is derived for the user.

10. Method according to any one of claims 1 to 9, **characterised in that** an exceptional treatment process is carried out on faulty signals or signals with high attenuation.

11. Method according to any one of claims 1 to 10, **characterised in that** after conditioning and protection by means of at least one electrical module (26, 27), the signal is recorded by means of at least one A/D converter (28) and is stored in at least one digital memory (29).

12. Method according to any one of claims 1 to 11, **characterised in that** the initiation of an impulse results in a trigger signal being produced, which stops the data recording process after a delay time.

13. Method according to any one of claims 1 to 11, **characterised in that** the storage process is started only once a trigger event has been identified.

14. Method according to any one of claims 1 to 13, **characterised in that** the capacitance of the impulse capacitor (10) and/or the equipment-specific inductances and/or at least tabular values of the inductance of the measurement objects and/or optionally lengths and the type of the sections of the cables are stored and can be called up in a memory in the evaluation circuit.

15. Method according to any one of claims 1 to 14, **characterised in that** the equipment's self-inductance is determined by means of a calibration measurement, by a short circuit at the end of the measurement lines.

16. Evaluation circuit for fault tracing on branched low-voltage and medium-voltage networks by means of an impulse method, **characterised in that** the evaluation circuit contains at least one conditioning and protection module (26, 27), at least one A/D converter (28), at least one memory (29) and at least one evaluation computer (30) for the signal, wherein the evaluation computer is suitable to carry out all the steps of the method according to any one of claims 1 to 15 and 26 to 35.

17. Evaluation circuit according to claim 16, **characterised in that** the at least one conditioning and protection module (26, 27) is followed by the at least one A/D converter (28), which is followed by the at least one memory (29), which is in turn followed by the at least one evaluation computer (30).

18. Evaluation circuit according to either of claim 16 or 17, **characterised in that** the conditioning and protection module (26, 27) contains at least one amplifier (26).

19. Evaluation circuit according to claim 18, **characterised in that** the amplifier (26) is connected to at least one voltage divider (27).

20. Evaluation circuit according to any one of claims 16 to 19, **characterised in that** the memory (29) is a digital memory.

21. Evaluation circuit according to any one of claims 16 to 20, **characterised in that** the memory (29) is a ring memory and is in the form of a transient memory.

22. Evaluation circuit according to any one of claims 16 to 21, **characterised in that** the evaluation computer (30) is suitable for carrying out the calculation steps for the method according to any one of claims 1 to 15.

23. Evaluation circuit according to claim 22, **characterised in that** the evaluation computer (30) is also suitable for calculating the lengths of the cables to be tested.

24. Evaluation circuit according to any one of claims 16 to 23, **characterised in that** at least one output appliance (31) and/or at least one input appliance (32) can be connected to the evaluation computer (30).

25. Evaluation circuit according to any one of claims 16 to 24, **characterised in that** the output appliance (31) contains at least one display and/or the input appliance (32) contains at least one keyboard.

26. Method according to any one of claims 1 to 15, **characterised in that** the quality of the transient response is determined and the calculation of the line inductance or of the measured frequency or period duration is corrected.

27. Method according to claim 26, **characterised in that** the quality of the transient response or of the resonant circuit is determined from the drop in the amplitudes of successive oscillations of the exponentially decaying transient process, and/or by the standardised rise in the zero crossing of the oscillation which represents the first derivative of the voltage waveform divided by the circuit frequency.

28. Method according to any one of claims 1 to 15 and 26 or 27, **characterised in that** the oscillation frequency is evaluated by simultaneous recording of the current and voltage and the complex time-dependent signal obtained in this manner is used for further evaluation.

29. Method according to claim 28, **characterised in that** in the case of objects with a very low quality (less than about 1.5) other times are also determined in order to allow calculation of the oscillation frequency, specifically the start of the current flow (sudden voltage change at the output) and/or the maximum of the current flow (zero crossing of u"(t)) and/or the first zero crossing of the voltage and/or the mid-time of the imaginary half-period.

30. Method according to any one of claims 1 to 15 and 26 or 27, **characterised in that** the oscillation frequency is evaluated by determining the zero crossings of the first and second mathematical derivative with respect to time and the zero crossings can also be used to determine the quality of the transient response or the resonant circuit.

31. Method according to any one of claims 1 to 15 and 26 or 27, **characterised in that** the oscillation frequency is evaluated by calculation in sections of the Thomson frequency, preferably between the short time periods of the zero crossings, where the arc resistance is approximately constant and, in addition, the discrepancies of the Thomson frequencies in sections are also calculated for monitoring and the mean value of the frequencies is formed for the overall result.

32. Method according to any one of claims 1 to 15 and 26 or 27, **characterised in that** noise and interference components in the recorded measurement signal are suppressed by low-pass filtering before the final measurement of the frequency and quality, with the filter band width being adaptively matched to the measurement signal that is present.

33. Method according to claim 32, **characterised in that** in order to ensure the correct effect of a non-causal filtering of the measurement signal (for example linear phase filtering, transversal filtering), the measurement signal to be filtered is extrapolated in the time periods before the striking of a fault arc and after the interruption of a fault arc using estimated values, obtained in advance, of the frequency and of the quality.

34. Method according to any one of claims 1 to 15 and 26 to 33, **characterised in that** the cable inductance is calculated using only one measurement with the aid of a tabulated cable impedance, with this correction being carried out only when the capacitance of the measurement object (cable) in comparison with the capacitance of the impulse generator cannot be ignored.

35. Method according to claim 34, **characterised in that** the tabulated cable impedance is calculated by means of a cable table, which has the capacitance added to it, and is stored in the appliance.

## Revendications

1. Procédé de localisation de défauts en particulier sur des réseaux basse et moyenne tension ramifiés, à l'aide d'une méthode à impulsions, selon lequel les étapes suivantes sont exécutées :

   a) recherche de la fréquence de l'élément basse fréquence du courant ou de la tension d'onde de choc ;
   b) calcul de l'inductance de circuit à l'aide de la "formule du circuit oscillant de Thomson" avec la capacité connue du condensateur de choc, à partir de la fréquence d'oscillation basse fréquence définie ;
   c) soustraction de l'inductance propre du condensateur de choc et de la ligne de mesure comme facteur de correction ;
   d) calcul de l'éloignement par rapport au lieu du défaut de câble, à partir de l'inductance calculée, par l'intermédiaire de l'inductance linéique de l'objet de mesure.

2. Procédé selon la revendication 1, **caractérisé en ce que** l'analyse de la fréquence d'oscillations se fait manuellement ou automatiquement, à l'aide d'une technique de mesure, grâce à la mesure des écartements des passages par zéro et/ou des valeurs extrêmes.

3. Procédé selon la revendication 1 ou 2,
   **caractérisé en ce que** l'analyse de la fréquence d'oscillations se fait par FFT (transformée de Fourier rapide) et/ou CZT (transformée Chirp-Z).

4. Procédé selon la revendication 3, **caractérisé en ce que** la recherche du maximum se fait dans la représentation FFT et/ou (CZT).

5. Procédé selon l'une des revendications 1 à 4, **caractérisé en ce qu'**il est prévu une recherche des passages par zéro de tension pour contrôler la fréquence d'oscillations en vue de détecter les défauts, lors de l'analyse.

**6.** Procédé selon l'une des revendications 1 à 5, **caractérisé en ce qu'**un filtrage passe-bas de parties transitoires a lieu.

**7.** Procédé selon l'une des revendications 1 à 6, **caractérisé en ce qu'**il est prévu un contrôle de continuité du signal pour détecter des ruptures et des arcs électriques défectueux discontinus.

**8.** Procédé selon l'une des revendications 1 à 7, **caractérisé en ce que** la recherche de la qualité du circuit a lieu à partir de l'atténuation d'amplitude, pour juger la qualité de l'arc électrique.

**9.** Procédé selon l'une des revendications 1 à 8, **caractérisé en ce qu'**il est prévu une détection de défauts à la terre ou une décharge disruptive vers la terre à partir du signal, et une dérivation d'un avertissement de sécurité pour l'utilisateur.

**10.** Procédé selon l'une des revendications 1 à 9, **caractérisé en ce qu'**il est prévu un traitement exceptionnel de signaux perturbés ou de signaux avec un amortissement élevé.

**11.** Procédé selon l'une des revendications 1 à 10, **caractérisé en ce que** le signal est détecté après un conditionnement et une protection à l'aide d'au moins un composant électrique (26, 27) avec au moins un convertisseur analogique/numérique (28), et est stocké dans une mémoire numérique (29).

**12.** Procédé selon l'une des revendications 1 à 11, **caractérisé en ce que** grâce au déclenchement du choc est produit un signal de déclenchement qui arrête la saisie de données après un temps de retard.

**13.** Procédé selon l'une des revendications 1 à 11, **caractérisé en ce que** l'opération de stockage n'est démarrée qu'une fois qu'un événement de déclenchement a été détecté.

**14.** Procédé selon l'une des revendications 1 à 13, **caractérisé en ce que** la capacité du condensateur de choc (10) et/ou les inductances spécifiques de l'appareil et/ou au moins des valeurs tabellaires de l'inductance linéique des objets de mesure et/ou éventuellement les longueurs et le type des tronçons des câbles sont stockés et aptes à être appelés dans une mémoire du circuit d'analyse.

**15.** Procédé selon l'une des revendications 1 à 14, **caractérisé en ce que** l'inductance propre à l'appareil est recherchée à l'aide d'une mesure de calibrage par court-circuit à l'extrémité des lignes de mesure.

**16.** Circuit d'analyse pour la localisation de défauts sur des réseaux basse et moyenne tension ramifiés, à l'aide d'une méthode à impulsions, **caractérisé en ce que** le circuit d'analyse contient au moins un module de conditionnement et de protection (26, 27), au moins un convertisseur analogique/numérique (28), au moins une mémoire (29) et au moins un ordinateur d'analyse (30) pour le signal, l'ordinateur d'analyse étant apte à effectuer toutes les étapes du procédé selon l'une des revendications 1 à 15 et 26 à 35.

**17.** Circuit d'analyse selon la revendication 16,
**caractérisé en ce qu'**il est prévu en aval du ou des modules de conditionnement et de protection (26, 27) le ou les convertisseurs analogique/numérique (28), en aval desquels est prévue au moins la mémoire (29), en aval de laquelle est prévu le ou les ordinateurs d'analyse (30).

**18.** Circuit d'analyse selon la revendication 16 ou 17, **caractérisé en ce que** le module de conditionnement et de protection (26, 27) contient au moins un amplificateur (26).

**19.** Circuit d'analyse selon la revendication 18,
**caractérisé en ce que** l'amplificateur (26) est relié à au moins un diviseur de tension (27).

**20.** Circuit d'analyse selon l'une des revendications 16 à 19, **caractérisé en ce que** la mémoire (29) est une mémoire numérique.

**21.** Circuit d'analyse selon l'une des revendications 16 à 20, **caractérisé en ce que** la mémoire (29) est une mémoire circulaire et est conçue comme une mémoire transitoire.

**22.** Circuit d'analyse selon l'une des revendications 16 à 21, **caractérisé en ce que** l'ordinateur d'analyse (30) est apte à effectuer les étapes de calcul du procédé selon l'une des revendications 1 à 15.

23. Circuit d'analyse selon la revendication 22, **caractérisé en ce que** l'ordinateur d'analyse (30) est également apte à effectuer un calcul de longueur des câbles à tester.

24. Circuit d'analyse selon l'une des revendications 16 à 23, **caractérisé en ce qu'**au moins un appareil de sortie (31) et/ou au moins un appareil d'entrée (32) sont aptes à être raccordés à l'ordinateur d'analyse (30).

25. Circuit d'analyse selon l'une des revendications 16 à 24, **caractérisé en ce que** l'appareil de sortie (31) contient au moins un affichage et/ou l'appareil d'entrée (32) contient au moins un clavier.

26. Procédé selon l'une des revendications 1 à 15, **caractérisé en ce qu'**on définit la qualité de l'opération d'évanouissement, et une correction du calcul de l'inductance de ligne ou de la fréquence ou période mesurée.

27. Procédé selon la revendication 26, **caractérisé en ce que** la définition de la qualité de l'opération d'évanouissement ou du circuit oscillant se fait à partir de la baisse des amplitudes d'oscillations successives de l'opération d'évanouissement qui diminue de manière exponentielle et/ou grâce à l'augmentation normée dans le passage par zéro de l'oscillation, qui représente la première dérivation de la forme de tension divisée par la fréquence angulaire.

28. Procédé selon l'une des revendications 1 à 15 et 26 ou 27, **caractérisé en ce que** l'analyse de la fréquence d'oscillations se fait grâce à une détection simultanée de courant et de tension, et utilise le signal complexe, dépendant du temps, qui est ainsi obtenu, pour la suite de l'analyse.

29. Procédé selon la revendication 28, **caractérisé en ce que** dans le cas d'objets de qualité très basse (de moins de 1,5), on définit encore d'autres moments, en supplément, pour permettre un calcul de la fréquence d'oscillations, à savoir le début de la conduction (saut de tension à la sortie) et/ou le maximum de la conduction (passage par zéro de u"(t)) et/ou le premier passage par zéro de la tension et/ou le moment central de la demi-période imaginée.

30. Procédé selon l'une des revendications 1 à 15 et 26 ou 27, **caractérisé en ce que** l'analyse de la fréquence d'oscillations se fait grâce à la définition des passages par zéro des première et seconde dérivations mathématiques temporelles, qui peuvent aussi être utilisées pour définir la qualité de l'opération d'évanouissement ou du circuit oscillant.

31. Procédé selon l'une des revendications 1 à 15 et 26 ou 27, **caractérisé en ce que** l'analyse de la fréquence d'oscillations se fait grâce au calcul par segments de la fréquence Thomson, de préférence entre les courtes périodes des passages par zéro, où la résistance de l'arc est approximativement constante, et on calcule encore en supplément les écarts des fréquences Thomson par segments, pour le contrôle, et on forme pour le résultat global la valeur moyenne des fréquences.

32. Procédé selon l'une des revendications 1 à 15 et 26 ou 27, **caractérisé en ce que** pour supprimer les niveaux de bruit et les composantes perturbatrices dans le signal de mesure détecté, un filtrage passe-bas a lieu avant la mesure définitive de la fréquence et de la qualité, la largeur de bande filtrante étant adaptée de manière adaptative au signal de mesure présent.

33. Procédé selon la revendication 32, **caractérisé en ce que** pour assurer l'effet correct d'un filtrage non causal du signal de mesure (par exemple filtrage de phase linéaire, filtrage transversal), le signal de mesure à filtrer est extrapolé dans les périodes situées avant l'amorçage de l'arc électrique défectueux et après la rupture de celui-ci, à l'aide de valeurs d'évaluation de la fréquence et de la qualité recueillies précédemment.

34. Procédé selon l'une des revendications 1 à 15 et 26 à 33, **caractérisé en ce que** l'inductance de câble est calculée avec une mesure seulement, à l'aide d'une impédance de câble sous forme de tableau, cette correction n'ayant lieu que si la capacité de l'objet de mesure (câble) ne peut pas être négligée par rapport à la capacité du générateur de choc.

35. Procédé selon la revendication 34, **caractérisé en ce que** l'impédance de câble sous forme de tableau est calculée à l'aide d'un tableau de câble, complété suivant la capacité linéique, qui est stocké dans l'appareil.

## Fig. 1

## Fig. 2

## Fig. 10

Tastatur 32

Auswete-
Rechner 30

Speicher

Display 31

A / D

Fig. 3

Fig. 4

Fig. 5

Fig. 6

Fig. 7

Fig. 6a

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0768537 A
- US 4630228 A
- US 6124717 A
- DE 10136344